(19) Europäisches Patentamt

European Patent Office

Office européen des brevets

(11) **EP 1 050 126 B1**

(12) **EUROPÄISCHE PATENTSCHRIFT**

| | |
|---|---|
| (45) Veröffentlichungstag und Bekanntmachung des Hinweises auf die Patenterteilung:<br>**18.08.2004 Patentblatt 2004/34** | (51) Int Cl.$^7$: **H04J 3/06**, H03L 7/081,<br>H03L 7/093 |
| (21) Anmeldenummer: **99904719.4** | (86) Internationale Anmeldenummer:<br>**PCT/DE1999/000095** |
| (22) Anmeldetag: **18.01.1999** | (87) Internationale Veröffentlichungsnummer:<br>**WO 1999/038284 (29.07.1999 Gazette 1999/30)** |

(54) **DIGITAL GESTEUERTE SCHALTUNG ZUR VERRINGERUNG DER PHASENMODULATION EINES SIGNALS**

DIGITALLY CONTROLLED CIRCUIT FOR REDUCING THE PHASE MODULATION OF A SIGNAL

CIRCUIT A COMMANDE NUMERIQUE POUR REDUIRE LA MODULATION DE PHASE D'UN SIGNAL

| | |
|---|---|
| (84) Benannte Vertragsstaaten:<br>**DE FR GB IT** | • **HINZ, Torsten**<br>**D-41468 Neuss (DE)** |
| (30) Priorität: **20.01.1998 DE 19802001** | (74) Vertreter: **Reinhard - Skuhra - Weise & Partner**<br>**Postfach 44 01 51**<br>**80750 München (DE)** |
| (43) Veröffentlichungstag der Anmeldung:<br>**08.11.2000 Patentblatt 2000/45** | |
| (73) Patentinhaber: **Infineon Technologies AG**<br>**81669 München (DE)** | (56) Entgegenhaltungen:<br>**EP-A- 0 692 878     WO-A-96/28889**<br>**DE-A- 3 942 883     US-A- 5 502 750** |
| (72) Erfinder:<br>• **PITZER, Armin**<br>**D-47800 Krefeld (DE)** | |

**Beschreibung**

Die vorliegende Erfindung betrifft eine digital gesteuerte Schaltung zur Verringerung der Phasenmodulation (Jitter) eines Signals. Gleichzeitig kann mit der vorliegenden Schaltung eine Taktratenumwandlung durchgeführt werden.

Die Phasenmodulation eines Signals wird in der Fachsprache üblicherweise als "Jitter" bezeichnet. Der Jitter ist meist sinusförmig und wird durch eine Jitter-Frequenz und eine Jitter-Amplitude bestimmt.

Bei der digitalen Signalverarbeitung wird beabsichtigt, möglichst ohne analoge Komponenten auszukommen. Insbesondere soll erreicht werden, daß die Schaltungen vollständig in einer integrierten Schaltung ohne externe Komponenten aufgebaut werden können. Schaltungen zur Verringerung der Phasenmodulation (Jitter-Attenuatoren) gemäß dem Stand der Technik benötigen üblicherweise externe Komponenten. Dadurch entstehen zusätzliche Technologie- und Temperaturabhängigkeiten und Nichtlinearitäten der externen Komponenten. Gleichzeitig wird mehr Platz auf der Platine verbraucht und es entstehen höhere Kosten. Die bekannten Jitter-Attenuatoren beinhalten immer noch analoge Schaltungen. Dadurch entstehen weitere Technologieabhängigkeiten, Nichtlinearitäten in dem Jitter-Dämpfungsverhalten und unter Umständen auch Resonanzprobleme.

Es sind zwar bereits digitale Jitter-Attenuatoren bekannt, beispielsweise aus der US 5 493 243 A1. Diese weisen jedoch einen relativ großen "Intrinsic-Jitter", d.h. eine systemimmanente Phasenmodulation, auf. Die bekannten digitalen Jitter-Attenuatoren besitzen darüber hinaus ein phasendifferenzabhängiges Korrekturintervall und kein zeitkontinuierliches Erfassen und Auswerten der Phasendifferenz.

Aus den US 5 502 750 A1 und US 5 602 882 A1 ist jeweils ein Jitter-Attenuator für ein Empfangssignal bekannt geworden. Dabei ist dem Phasenkomparator ein Vorwärts-/Rückwärtszähler nachgeordnet.

Es ist Aufgabe der vorliegenden Erfindung, einen phasenmodulationsfreien (entjitterten) Takt (Clock) digital und ohne die Nutzung externer Komponenten zu generieren, der einer dynamischen Änderung der Frequenz präzise folgen kann.

Erfindungsgemäß wird diese Aufgabe mit einem Vielphasen-Taktgenerator, der N-Phasen eines Takts erzeugt, der das M-fache des verjitterten Signals beträgt und einem Multiplexer mit N-Eingängen für die N-Phasen des Takts und einem Ausgang, der das Ausgangssignal liefert, gelöst, wobei das Ausgangssignal und das verjitterte Signal mit den Eingängen eines Phasenkomparators verbunden sind, dessen Ausgangssignal einem Sigma-Delta-Modulator zugeführt wird, dessen Ausgangssignale zur Steuerung des Multiplexers dienen. Grundsätzlich sind Sigma-Delta-Modulatoren bekannt. Bisher wurden diese Modulatoren jedoch im Stand der Technik nur zur Gewinnung nicht ganzzahliger Bruchteile von Frequenzen genutzt. Das Prinzip des Sigma-Delta-Modulators basiert auf der Phasenfehler-Akkumulation. Mit jedem Grundtakt wird der Phasenfehler zwischen dem Grundtakt und dem von der Regelung geforderten Takt neu berechnet und gleichzeitig ausgewertet.

Um auch größere Phasendifferenzen verarbeiten zu können, ist es bevorzugt, zwischen dem Phasenkomparator und dem Sigma-Delta-Modulator einen Phasendifferenzakkumulator und einen Phasendifferenztransformer anzuordnen.

Sofern kein ganzzahliges Verhältnis zwischen dem Mastertakt und dem verjitterten Signal vorliegt, wird das verjitterte Signal über einen weiteren Sigma-Delta-Modulator zur Taktratenumwandlung dem entsprechenden Eingang des Phasenkomparators zugeführt.

Dabei ist es zur Herabsetzung der Power Consumption und der Geschwindigkeitsanforderungen an die Bauelemente von Phasendifferenzakkumulator, Phasendifferenztransformer und Sigma-Delta-Modulator bevorzugt, das Ausgangssignal über eine Teilerschaltung herabzusetzen, und das herabgesetzte Ausgangssignal dem Phasendifferenzakkumulator und dem Sigma-Delta-Modulator zuzuführen. Die Ausgangssignale des Sigma-Delta-Modulators werden über eine Flankenerkennungsschaltung dem Multiplexer und der Teilerschaltung zugeführt werden, wobei diese Flankenerkennungsschaltung von dem Mastertakt-Ausgangssignal angesteuert werden.

Es ist dabei besonders bevorzugt, daß das Teilerverhältnis der Teilerschaltung dem Verhältnis von dem Ausgangssignal zu dem verjitterten Signal, gegebenenfalls nach der Taktratenumwandlung durch den weiteren Sigma-Delta-Modulator, entspricht.

Der Sigma-Delta-Modulator zur Unterdrückung der Phasenmodulation kann besonders günstig und einfach als Binäraddierer ausgeführt werden, der die vom Phasenkomparator kommenden Werte aufaddiert, und die Überlauf- bzw. Unterlaufausgänge des Addierers können dann direkt zur Erzeugung der Korrekturbefehle dienen.

Der Phasendifferenzakkumulator weist vorzugsweise eine Schaltung zur Erkennung eines Über- oder Unterlaufs des Phasendetektors auf, deren Ausgang mit einem Zähler verbunden ist, der bei jedem Überlauf hoch- und bei jedem Unterlauf heruntergezählt wird.

Die Erfindung wird im folgenden anhand des in den Zeichnungen dargestellten Ausführungsbeispiels näher erläutert. Es zeigen:

FIGUR 1        ein grobes Blockschaltbild einer erfindungsgemäßen Schaltung;

FIGUR 1a    eine ergänzte Version des Schaltbildes der Figur 1;

FIGUR 2    ein Blockschaltbild des Phasendifferenzakkumulators der vorliegenden Schaltung;

FIGUR 3    ein Blockschaltbild des Sigma-Delta-Modulators für die Phasenmodulationsdämpfung;

FIGUR 4    ein Blockschaltbild des Sigma-Delta-Modulators zur Taktratenumwandlung; und

FIGUR 5    ein Blockschaltbild der Teiler- und Multiplexeransteuerschaltung.

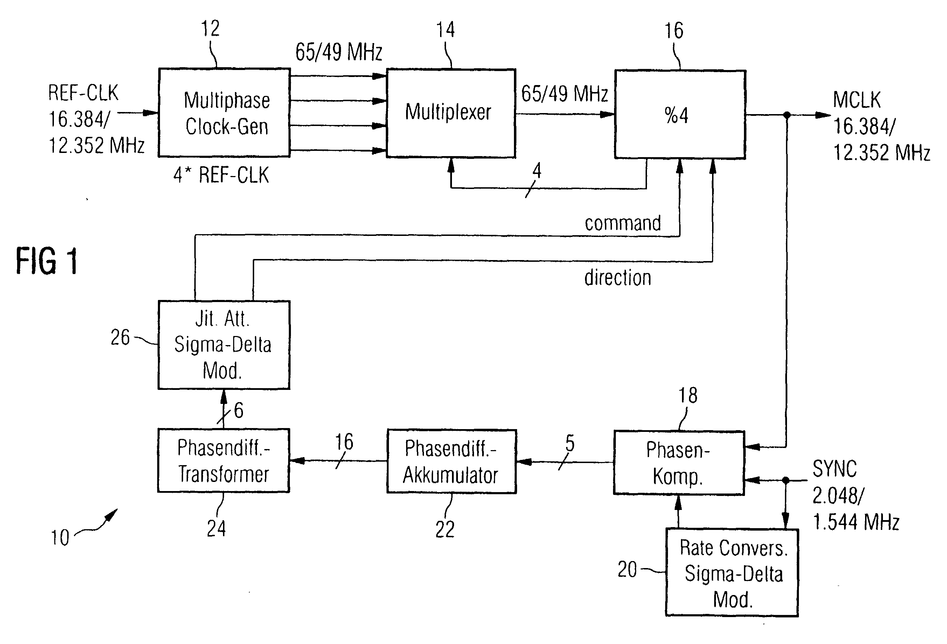

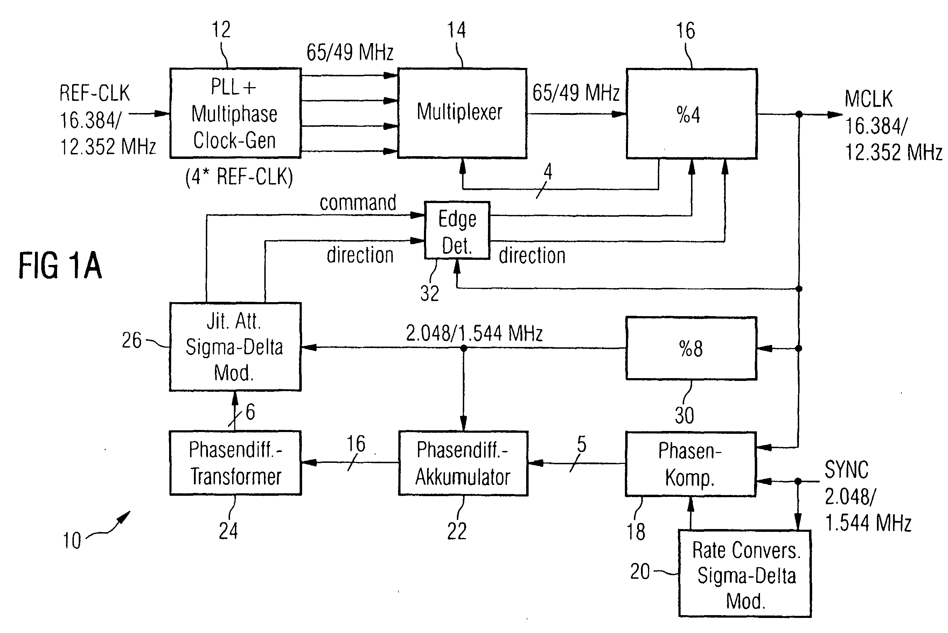

Figur 1 zeigt das grobe Blockschaltbild einer erfindungsgemäßen digital gesteuerten Schaltung zur Verringerung der Phasenmodulation eines Signals einschließlich einer Taktratenumwandlung unter Benutzung eines Sigma-Delta-Modulators. Ein verjittertes Eingangssignal SYNC wird dabei mit einem Mastertakt MCLK verglichen. Letzterer stellt gleichzeitig das Ausgangssignal der Schaltung dar. Die ermittelte Phasendifferenz wird in einem Sigma-Delta-Modulator integriert. Das Prinzip des Sigma-Delta-Modulators basiert auf der Phasenfehler-Akkumulation. Mit jedem Grundtakt wird der Phasenfehler zwischen MCLK und dem von der Regelung geforderten MCLK neu berechnet und gleichzeitig ausgewertet. Es soll damit ein entjitterter Clock MCLK digital und ohne die Nutzung externer Komponenten generiert werden, der für E1/T1-Applikationen im Frequenzbereich von 2,048/1,544 MHz oder Vielfachem davon benötigt wird.

Die Schaltung 10 wird mit einem Referenztakt REF-CLK versorgt, der eine beliebige und auch beliebig schwankende Phasenlage gegenüber dem Eingangssignal SYNC hat. Bei dem vorliegenden Ausführungsbeispiel kann der Referenztakt eine Frequenz von 16,384 oder 12,352 MHz haben. Dieser Referenztakt wird einem Multiphasentaktgenerator 12, der als Ringoszillator realisiert ist, zugeführt. Dieser erzeugt die vierfache Frequenz (4 x REF-Clock) in vier jeweils um 90 Grad versetzten Phasenlagen. Es liegen also am Ausgang des Multiphasentaktgenerators 12 vier um jeweils 90 Grad Phasenlage beabstandete Taktsignale mit 65 bzw. 49 MHz vor. Diese vier Signale werden einem Multiplexer 14 zugeführt, der eines der Signale auswählt, und dieses einer Teilerschaltung 16 zuführt. Die Teilerschaltung 16 setzt die Taktrate auf 1/4 herab und steuert gleichzeitig den Zeitpunkt, zu dem Auswahlsignale an den Multiplexer 14 weitergeleitet werden. Aufbau und Funktion der Teilerschaltung 16 werden weiter unten im einzelnen beschrieben.

Das Ausgangssignal MCLK wird einem Phasenkomparator 18 zugeführt. Dieser Phasenkomparator 18 verfügt über einen weiteren Eingang, an dem das verjitterte Eingangssignal SYNC anliegt. Sofern die Frequenz des Eingangssignals SYNC nicht ein Achtel der Frequenz MCLK beträgt, wird das Eingangssignal SYNC zuerst einem Sigma-Delta-Modulator 20 zugeführt, der der Anpassung der Frequenz des Eingangssignals SYNC auf 1/8 der Frequenz MCLK dient. Die Funktion dieses Sigma-Delta-Modulators 20 wird im einzelnen weiter unten erläutert.

Der Phasenkomparator 18 ermittelt die Phasendifferenz zwischen dem Mastertakt MCLK und dem mehr oder weniger verjitterten SYNC-Takt. Die Phasendifferenz wird in $2\pi/8$ Schritten aufgelöst, d.h. in Schritten von 45 von 360°. Der SYNC-Takt wird dabei eingangsseitig auf den MCLK-Takt synchronisiert. Mit Hilfe eines Zählers kann das Fehlen des SYNC-Taktes detektiert werden. In diesem Fall wird die gespeicherte Phasendifferenz gelöscht.

Herzstück des Phasenkomparators 18 ist ein 5 Bit-Zähler, der mit jedem MCLK-Takt dekrementiert wird. Mit jeder detektierten SYNC-Flanke wird 8 zum aktuellen Zählerstand addiert und das Ergebnis in einem Buffer gespeichert. Der in 2er-Komplement-Darstellung vorliegende Bufferwert repräsentiert die Phasenabweichung in Schritten von $2\pi/8$. Der maximale speicherbare Phasendifferenzbetrag beträgt somit $16 * 2\pi/8 = 4\pi$.

Die tatsächlich auftretende Phasenabweichung ist in der Praxis aber wesentlich größer, es können Abweichungen von bis zu +/- $280\pi$ auftreten. Dabei wird immer ein sinusförmiger Jitterverlauf ohne Sprünge zugrundegelegt. Es ist somit erforderlich, den Detektionsbereich der Phasenabweichung zu vergrößern. Dies erfolgt dadurch, daß dem Phasenkomparator 18 ein Phasendifferenzakkumulator 22 nachgeschaltet ist. Dem Eingang des Phasendifferenzakkumulators 22 werden die 5 Bit-Phasendifferenz des Phasenkomparators 18 zugeführt. Im Phasendifferenzakkumulator 22 wird dieser 5 Bit-Wert der Phasendifferenz des Phasenkomparators 18 jeweils mit der vorhergehenden Differenz verglichen. Wird ein Überlauf (Wechsel von 11111 auf 00000) detektiert, wird ein 11 Bit-Zähler 206 um 1 hochgezählt, im Falle eines Unterlaufs (Wechsel von 00000 auf 11111) wird der Zähler 206 heruntergezählt. Gleichzeitig wird ein Überlauf- bzw. Unterlauftest des 11 Bit-Zählers 206 durchgeführt. Sofern ein Überlauf oder Unterlauf des 11 Bit-Zählers 206 vorliegt, wird die Addition bzw. Subtraktion ausgesetzt. Der 11 Bit-Zählerstand des Phasendifferenzakkumulators 22 und die 5 Bit-Phasendifferenz des Phasenkomparators 18 wird in dem Phasendifferenzakkumulator 22 als 16 Bit-Wert gespeichert und steht am Ausgang des Phasendifferenzakkumulators 22 zur Verfügung.

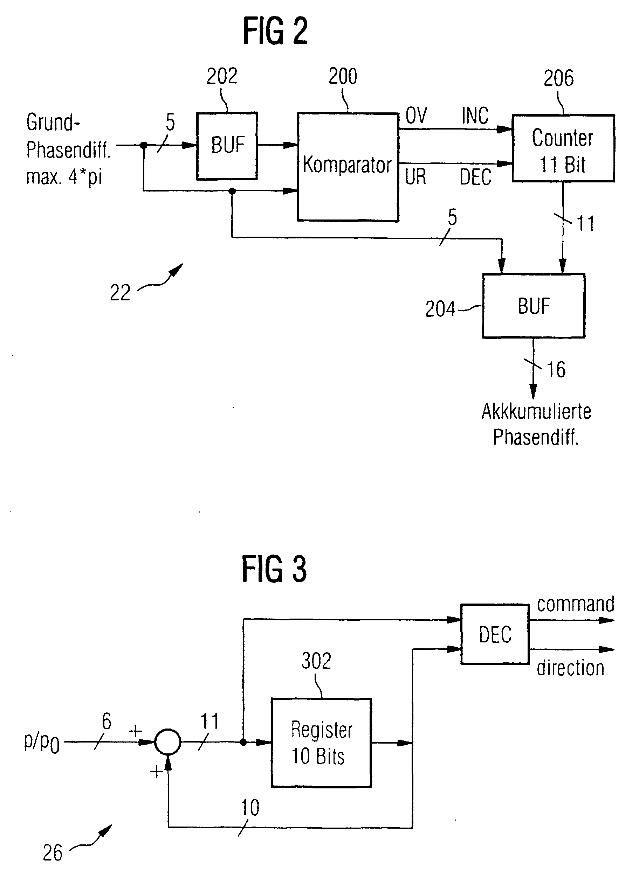

Der schaltungstechnische Aufbau des Phasendifferenzakkumulators 22 ist in Figur 2 im einzelnen dargestellt. Die 5-Bit-Grund-Phasendifferenz (entsprechend maximal 4 pi) vom Phasenkomparator 18 wird einem Komparator 200 einmal direkt und einmal über einen Buffer 202 zugeführt. Gleichzeitig wird diese Grundphasendifferenz den fünf niederwertigsten Bits eines Ausgangsbuffers 204 mit einer Gesamtwortbreite von 16 Bit zugeführt.

Der Komparator 200 verfügt über zwei Ausgänge Überlauf (OV) und Unterlauf (UR). Diese beiden Ausgänge sind mit den Eingängen Hochzählen (INC) und Herunterzählen (DEC) eines 11 Bit-Zählers 206 verbunden. Der Zählerstand des Zählers 206 wird in die elf höchstwertigen Bits des Ausgangsbuffers 204 übertragen. Somit liegt am Ausgang des Ausgangsbuffers 204 des Phasendifferenzakkumulators 22 die akkumulierte Phasendifferenz in einer Wortlänge von 16 Bit vor. Der 16 Bit-Ausgangswert des Phasendifferenzakkumulators 22 wird einem Phasendifferenztransformer 24 zugeführt. Der Phasendifferenztransformer ermittelt aus der erweiterten Phasendifferenz (16 Bit, 2er-Komplement) die Eingangsgröße für einen weiteren Sigma-Delta-Modulator 26. Der Phasendifferenztransformer 24 wird hier verwendet, da der Sigma-Delta-Modulator 26 lediglich ein 6 Bit breites Eingangssignal verarbeitet. Im übrigen dient er der Einstellung der Reglercharakteristik der Schaltung. Dabei wird die Phasendifferenz in Frequenz-Modifikationsschritte (ppm) mit 6 Bit im 2er-Komplement transformiert. Dazu wird die Phasendifferenz zunächst durch einen programmierbaren Wert von 2 bis 256 geteilt. Mit dieser Operation kann die Eckfrequenz des P-Reglers variiert werden. Die erfindungsgemäße Schaltung kann so auf die unterschiedlichen Systemanforderungen bzw. Normen eingestellt werden. Anschließend wird die Phasendifferenz auf 6 Bit reduziert. Dazu werden die sechs niederwertigsten Bits der modifizierten Phasendifferenz unverändert an den Sigma-Delta-Modulator durchgereicht, solange der Wert der gesamten Phasendifferenz kleiner als +31 und größer als -32 ist. Andernfalls wird der Korrekturwert für den Sigma-Delta-Modulator 26 auf +31 bzw. -32 begrenzt.

Der Sigma-Delta-Modulator 26 steuert die eigentliche Phasenmodulationsdämpfung. Er ermittelt nämlich die Steuergröße für die Modifikation des REF-CLK mit 16,384 bzw. 12,352 MHz. Der Aufbau dieses Sigma-Delta-Modulators 26 ist in Figur 3 dargestellt. Ein 10 Bit-Register 302 verwaltet die Phasendifferenz zwischen dem tatsächlichen MCLK und dem von der Regelung gewünschten MCLK. Der Wert, der mit jedem Takt zum Inhalt des Registers 302 addiert oder davon subtrahiert wird, ist direkt proportional zum Phasenfehler zwischen MCLK und dem von der Regelung gewünschten MCLK. Wenn der gesamte aufgelaufene Phasenfehler groß genug ist, löst der Sigma-Delta-Modulator 26 eine Taktkorrektur aus. Der Indikator dafür ist das Überlaufen des Registers.

In der hier dargestellten Ausführungsform der Erfindung kann der Teiler 16 und der Multiplexer 14 eine Periode des REF-CLK-Taktes um 1/16 Takt verlängern oder verkürzen. Dies entspricht 1/16 von 1/16,384 MHz = 61,04 ns/16 = 3,81 ns bzw. 1/16 von 12,352 MHz = 5,06 ns. Bei der gewählten Größe des Registers 302 von 10 Bit kann ein Phasenfehler von 1024 aufsummiert werden, bis es zum Überlauf kommt. D.h., ein Phasenfehler von 1 in diesem Register 302 entspricht einem realen Phasenfehler zwischen dem Takt MCLK und dem gewünschten MCLK von 3,81 ns / 1.024 = 3,73 ps. Die gewünschte Frequenz kann mit dem Eingangswert am Akkumulator eingestellt werden: Um so größer der Wert, um so größer die Phasenabweichung pro Takt zwischen dem gewünschten und dem realen MCLK, um so eher der Akkumulatorüberlauf, um so öfter eine Taktkorrektur.

Der Vorteil der Verwendung des Sigma-Delta-Modulators liegt darin, daß bei einer dynamischen Änderung der von der Regelung gewünschten Frequenz sich dieses sofort in der Phasenakkumulation wiederspiegelt. Die bisher summierte Phasendifferenz zwischen dem realen und dem gewünschten MCLK wird nicht gelöscht, sondern direkt mit in die Korrekturansteuerung eingebunden.

Der verwendete Sigma-Delta-Modulator 26 ist in einer besonders bevorzugten Ausführungsform als Binäraddierer realisiert. Mit jedem Takt wird der am Eingang liegende, vom Phasendifferenztransformer 24 kommende Wert aufaddiert. Aus dem Über- oder Unterlauf des Registers 302 wird der Korrekturbefehl und die Korrekturrichtung dekodiert und an den Teiler 16 weitergereicht. Bei der Wahl des Teilungsfaktors 2 im Phasendifferenztransformer 24 ergibt sich der Proportionalfaktor der Regelung zu 7,6 ppm Frequenzveränderung pro $2\pi/4$ Phasenabweichung zwischen MCLK und SYNC. Es ergibt sich folgende Tabelle:

| Phasenfehler in Zeiteinheiten im E1 Mode | Akku |
|---|---|
| - 3,8 ns/2 | 0 |
| 0 ns | 511 |
| +3,8 ns/2 | 1023 |
| (Kleinste Korrektureinheit = 3,8 ns in E1/5,06 ns in T1.) | |

In Abhängigkeit von den durch den Sigma-Delta-Modulator 26 erzeugten Steuerbefehlen COMMAND und DIRECTION wird der Teiler 16 und der Multiplexer 14 dergestalt gesteuert, daß am Ausgang ein auf das Eingangssignal SYNC synchronisiertes Ausgangssignal MCLK vorliegt.

Der Multiplexer 14 schaltet eine der vier 65/49 MHz-Clock-Phasen weiter. Der Teiler 16 dividiert den 65/49 MHz-Takt durch 4 und bestimmt in Abhängigkeit von den Ausgangsgrößen des Sigma-Delta-Modulators 26 die erforderliche 65/49 MHz-Taktphase. Durch das Weiterschalten von einer Taktphase zur nächsten wird eine Verkürzung bzw. Verlängerung um jeweils 4 * 65.536 MHz = 262,144 MHz entsprechend 3,8 nsec bzw. 4 * 49,408 MHz = 197,632 MHz entsprechend 5,06 ns in T1 erreicht.

Das Ausgangssignal des Teilers 16 ist ein 16,384 / 12,352 MHz-Takt (MCLK), der relativ zu der vorhergehenden Clock-Periode verkürzt, verlängert oder auch gleich ist. Der Eigenjitter beträgt nur 0,0078 UI.

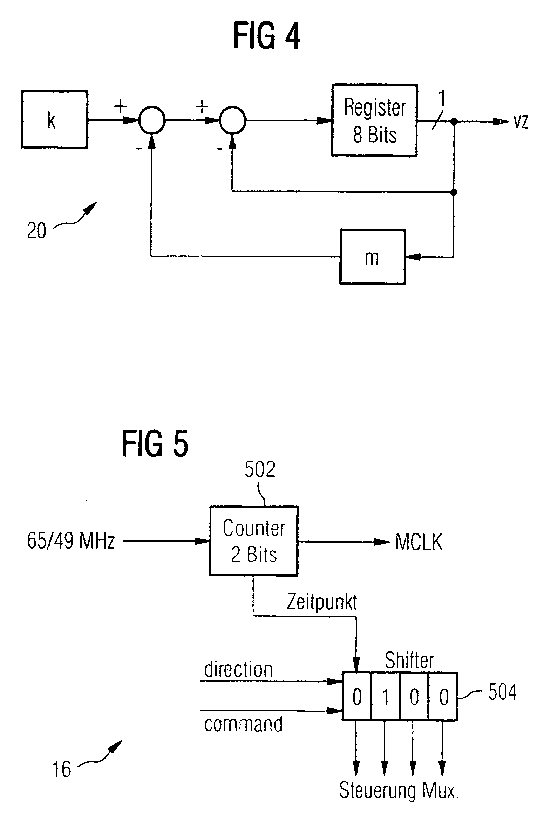

In Figur 5 ist der Aufbau des Teilers 16 nochmals im einzelnen dargestellt. Das 65/49 MHz-Signal, welches vom Multiplexer kommt, wird einem 2 Bit-Zähler 502 zugeführt. Dessen MSB liefert das Signal MCLK und gleichzeitig den Zeitpunkt, zu dem ein Schieberegister 504 freigeschaltet ist. Das Schieberegister ist vierstellig und enthält stets eine 1 und sonst nur Nullen. Die vier Ausgänge des Schieberegisters dienen der Steuerung des Multiplexers 14, in dem jeweils nur diejenige Phase aus dem Multiphasentaktgenerator 12 durch den Multiplexer 14 an den Teiler 16 weitergeschaltet wird, deren zugeordneter Platz im Schieberegister mit "1" belegt ist. Die Steuerung des Schieberegisters erfolgt über die Befehle DIRECTION und COMMAND vom Sigma-Delta-Modulator 26.

Die Funktion ist folgendermaßen: Sobald von dem Zähler 502 das "Zeitpunkt"-Signal am Schieberegister 504 eintrifft, werden die Eingänge für DIRECTION und COMMAND freigegeben. Sofern der COMMAND-Eingang auf Null liegt, verändert sich das Schieberegister 504 nicht. Ist der COMMAND-Eingang aktiv, wird abhängig von dem Status des DIRECTION-Eingangs die 1 um eine Stelle nach links oder nach rechts verschoben.

Die Figur 1a zeigt ein detaillierteres Blockschaltbild der erfindungsgemäßen Schaltung, bei der die interne Arbeitsfrequenz reduziert ist, um mit weniger schnellen Komponenten auszukommen. Hierzu wird der Takt MCLK durch einen weiteren Teiler 30 durch acht geteilt, so daß statt des MCLK-Takts von 16,384 bzw. 12,352 MHz ein Takt von 2,048 bzw. 1,544 MHz vorliegt. Dieser Takt wird dann als Arbeitstakt dem Phasendifferenzakkumulator 22 und dem Sigma-Delta-Modulator 26 zugeführt. Automatisch wird damit auch die Arbeitsgeschwindigkeit des Phasendifferenztransformers 24 entsprechend herabgesetzt. In diesem Fall müssen jedoch die Ausgangssignale des Sigma-Delta-Modulators 26 zur Ansteuerung des Teilers 16 wieder auf die nominale Frequenz von 16,384 bzw. 12,352 MHz heraufgesetzt werden. Die Signale COMMAND und DIRECTION sind daher zur Anpassung auf den Takt MCLK über einen Flankendetektor 32 geführt, der zwischen den Sigma-Delta-Modulator 26 und den Teiler 16 geschaltet ist. Dieser Flankendetektor wird von dem Signal MCLK angesteuert.

Die vorliegende Schaltung soll für Schaltungen gemäß den E1 / T1-Normen eingesetzt werden. Es können daher folgende Konstellationen auftreten:

REF-CLK (interner Arbeitstakt) = 16,384 MHz, SYNC = 2,048 oder 1,544 Mhz;

REF-CLK = 12,352 MHz, SYNC = 2,048 oder 1,544 Mhz.

In den Fällen, in denen SYNC ≠ 1/8 REF-CLK ist, muß eine Konversion der Datenraten von 2,048 auf 1,544 MHz oder umgekehrt durchgeführt werden. Hierzu wird zwischen den Eingang des Signals SYNC und den Phasenkomparator 18 der Sigma-Delta-Modulator 20 zur Taktratenumwandlung geschaltet, wie in den Figuren 1 und 1a dargestellt. Der Aufbau dieses Sigma-Delta-Modulators ist in Figur 4 detaillierter dargestellt. Dabei ist also eine taktsynchrone Frequenzteilung um jeweils einen nicht-ganzzahligen Teilerfaktor erforderlich.

Diese wird folgendermaßen realisiert:

1. Umwandlung 2,048 --> 1,544 MHz:

In diesem Fall liegt an REF-Clock eine Frequenz von 16,384 MHz an. Dies enspricht der 8-fachen Fequenz von 2,048 MHz. Über SYNC wird ein 1,544 MHz-Takt vorgegeben. Es gilt: 16,384 / 1,544 = 10,611399. Um diesen nicht ganzzahligen Teilerfaktor zu realisieren, wird abwechselnd der Teilerfaktor 10 und 11 gewählt. Wann welcher Divisor angewendet wird, entscheidet das "Vorzeichen" VZ des Sigma-Delta-Modulators. Für diesen Fall sind in Figur 4 folgende Werte einzusetzen: m = 21,5, k = 96,5.

Wenn das Register des Sigma-Delta-Modulators negativ ist, wird zum Register m + k = 118 addiert, im positiven Fall werden m - k = -75 addiert, also 75 subtrahiert. Die Häufigkeit, mit der durch 11 geteilt werden muß, um diesen nicht-ganzzahligen Teilerfaktor von 10,611399 zu realisieren, ergibt sich aus 118/(118+75); die Häufigkeit für den Teilerfaktor 10 ergibt sich zu 75/(118+75). Der Gesamtteilerfaktor ergibt sich somit zu:

$$11 * 118(118+75) + 10 * 75(118+75) = 10,611399.$$

2. Für die umgekehrte Konversion von 1,544 --> 2,048 MHz gilt: REF-CLK = 12,352 MHz; SYNC = 2,048 Mhz. Es ergibt sich somit 12,352 / 2,048 = 6,03125:

Es muß also abwechselnd durch 6 und 7 geteilt werden. Dazu ist in diesem Falle m = -45 und k = 48 zu wählen. Damit gilt: Wenn das Register negativ ist, wird m + k = 3 addiert, andernfalls werden m - k = -93 addiert, also 93 subtrahiert.

Zur weiteren Vereinfachung der Schaltung wird die Teilung indirekt im Phasenkomparator 18 durchgeführt, indem der additive Faktor von 8, der bei erkannter SYNC-Flanke zum Akkumulator hinzu addiert wird, für die Taktratenumwandlung durch die Faktoren 10 und 11 bzw. 6 und 7 ersetzt wird. Der Sigma-Delta-Modulator 20 wählt also lediglich die Zahl aus, die im Phasenkomparator 18 jeweils addiert werden muß.

Sofern MCLK und SYNC ganzzahlige Vielfache sind, arbeitet der Sigma-Delta-Modulator 20 nicht und es werden im Phasenkomparator stets 8 addiert.

Durch die hier beschriebene Ausführungsform der Erfindung wird der empfangene Jitter des SYNC-Signals gemäß einer P-Reglercharacteristik mit 20 db/Dekade gedämpft.

Die Erfindung ermöglicht damit folgende Vorteile:

- Lineare Jitter-Dämpfung
- unabhängiges Korrekturintervall zur aktuellen Phasendifferenz
- zeitkontinuierliches Erfassen und Auswerten der Phasendifferenz
- höhere Dynamik als bisherige digitale Konzepte
- in Grenzsituationen größere Genauigkeit
- optimales Jitter-Reduktionsverhalten
- sehr geringer schaltungsimmanenter (Intrinsic) Jitter
- keine externen Komponenten erforderlich
- keine Analog-Schaltung erforderlich
- geringer Platzbedarf auf einem IC (small silicon area)
- geringer Leistungsverbrauch
- Verwendung preisgünstiger Frequenzsynthesizer möglich.

**Patentansprüche**

1. Digital gesteuerte Schaltung zur Verringerung der Phasenmodulation eines Signals (SYNC) mit einem Vielphasen-Taktgenerator (12), der n-Phasen eines Takts (REF-CLK) erzeugt, der das m-fache des Signals (SYNC) beträgt und einem Multiplexer (14) mit n-Eingängen für die n-Phasen des Takts (REF-CLK) und einem Ausgang, der das Ausgangssignal (MCLK) liefert, wobei das Ausgangssignal (MCLK) und das Signal (SYNC) mit den Eingängen eines Phasenkomparators (18) verbunden sind,
   **dadurch gekennzeichnet, daß**
   das Ausgangssignal des Phasenkomparators einem Sigma-Delta-Modulator (26) zugeführt wird, dessen Ausgangssignale (command, direction) zur Steuerung des Multiplexers (14) dienen.

2. Schaltung nach Anspruch 1,
   **dadurch gekennzeichnet, daß** zwischen dem Phasenkomparator (18) und dem Sigma-Delta-Modulator (26) ein Phasendifferenz-Akkumulator (22) und ein Phasendifferenz-Transformer (24) angeordnet ist.

3. Schaltung nach Anspruch 1 oder 2,
   dadurch gekennzeicnnet, daß das Signal (SYNC) über einen weiteren Sigma-Delta-Modulator (20) zur Taktratenumwandlung dem entsprechenden Eingang des Phasenkomparators (18) zugeführt wird.

4. Schaltung nach einem der Ansprüche 1 bis 3,
   **dadurch gekennzeichnet , daß** die Ausgangssignale (command, direction) des Sigma-Delta-Modulators (26) über eine Flankenerkennungsschaltung (32) dem Multiplexer (14) zugeführt werden, die von dem Ausgangssignal (MCLK) angesteuert wird.

5. Schaltung nach Anspruch 4,
   **dadurch gekennzeichnet, daß** das Ausgangssignal (MCLK) einer Teilerschaltung (30) zugeführt wird, deren Ausgangssignal den Phasendifferenz-Akkumulator (22) und den Sigma-Delta-Modulator (26) ansteuert.

6. Schaltung nach Anspruch 5,
   **dadurch gekennzeichnet, daß** das Teilerverhältnis der Teilerschaltung (30) dem Verhältnis von dem Ausgangssignal (MCLK) zu dem Signal (SYNC), gegebenenfalls nach der Taktratenumwandlung durch den weiteren Sigma-Delta-Modulator (20), entspricht.

7. Schaltung nach einem der vorhergehenden Ansprüche,
   **dadurch gekennzeichnet, daß** der Sigma-Delta-Modulator (26) als Binäraddierer ausgeführt ist, der die vom Phasenkomparator (18) kommenden Werte aufaddiert, und die Überlauf- bzw. Unterlaufausgänge des Addierers zur Erzeugung der Korrekturbefehle (command, direction) dienen.

**8.** Schaltung nach einem der Ansprüche 2 bis 7,
**dadurch gekennzeichnet, daß** der Phasendifferenz-Akkumulator (22) eine Schaltung (200) zur Erkennung eines Über- oder Unterlaufes des Phasendetektors (18) aufweist, deren Ausgang mit einem Zähler (206) verbunden ist, der bei jedem Überlauf hoch- und bei jedem Unterlauf heruntergezählt wird.

**9.** Schaltung nach einem der Ansprüche 1 bis 8,
**dadurch gekennzeichnet, daß** als Wert für m und n jeweils 4 gewählt ist.

**Claims**

**1.** Digitally controlled circuit for reducing the phase modulation of a signal (SYNC) having a multiphase clock generator (12) which produces n phases of a clock (REF-CLK) which is m-times the signal (SYNC), and having a multiplexer (14) with n inputs for the n phases of the clock (REF-CLK) and with one output which supplies the output signal (MCLK), with the output signal (MCLK) and the signal (SYNC) being connected to the inputs of a phase comparator (18),
**characterized in that**
the output signal of the phase comparator is supplied to a sigma-delta modulator (26) whose output signals (command, direction) are used for controlling the multiplexer (14).

**2.** Circuit according to Claim 1,
**characterized in that** a phase-difference accumulator (22) and a phase-difference transformer (24) are arranged between the phase comparator (18) and the sigma-delta modulator (26).

**3.** Circuit according to Claim 1 or 2,
**characterized in that** the signal (SYNC) is supplied to the appropriate input of the phase comparator (18) via a further sigma-delta modulator (20) for clock rate conversion.

**4.** Circuit according to one of Claims 1 to 3,
**characterized in that** the output signals (command, direction) of the sigma-delta modulator (26) are supplied to the multiplexer (14) via an edge recognition circuit (32) which is actuated by the output signal (MCLK).

**5.** Circuit according to Claim 4,
**characterized in that** the output signal (MCLK) is supplied to a divider circuit (30) whose output signal actuates the phase-difference accumulator (22) and the signal-delta modulator (26).

**6.** Circuit according to Claim 5,
**characterized in that** the division ratio of the divider circuit (30) corresponds to the ratio of the output signal (MCLK) to the signal (SYNC), if appropriate after the clock-rate conversion by the further sigma-delta modulator (20).

**7.** Circuit according to one of the preceding claims,
**characterized in that** the sigma-delta modulator (26) is in the form of a binary adder which adds the values coming from the phase comparator (18), and the overflow and underflow outputs of the adder are used for producing the correction commands (command, direction).

**8.** Circuit according to one of Claims 2 to 7,
**characterized in that** the phase-difference accumulator (22) has a circuit (200) for recognizing an overflow or underflow of the phase detector (18), the output of which circuit (200) is connected to a counter (206) which counts upwards for any overflow and downwards for any underflow.

**9.** Circuit according to one of Claims 1 to 8,
**characterized in that** 4 is in each case chosen as the value for m and n.

**EP 1 050 126 B1**

**Revendications**

1. Circuit à commande numérique pour réduire la modulation de phase d'un signal (SYNC) comportant un générateur de cadence à phases multiples (12), qui produit n phases d'une cadence (REF-CLK), qui est égale à m fois celle du signal (SYNC), et un multiplexeur (14) comportant n entrées pour les n phases de la cadence (REF-CLK), et une sortie, qui délivre le signal de sortie (MCLK), le signal de sortie (MCLK) et le signal (SYNC) étant relié aux entrées d'un comparateur de phase (18),
**caractérisé en ce que**
le signal de sortie du comparateur de phase est envoyé à un modulateur sigma-delta (26), dont les signaux de sortie (commande, direction) sont utilisés pour commander le multiplexeur (14).

2. Circuit selon la revendication 1, **caractérisé en ce qu'**entre le comparateur de phase (18) et le modulateur sigma-delta (26) sont disposés un accumulateur de différence de phase (22) et un transformateur de différence de phase (24).

3. Circuit selon la revendication 1 ou 2, **caractérisé en ce que** le signal (SYNC) est envoyé par l'intermédiaire d'un autre modulateur sigma-delta (20), pour la conversion du rythme de cadence, à l'entrée correspondante du comparateur de phase (18).

4. Circuit selon l'une des revendications 1 à 3, **caractérisé en ce que** les signaux de sortie (commande, direction) du modulateur sigma-delta (26) sont envoyés par l'intermédiaire d'un circuit (32) d'identification de flancs, au multiplexeur (14), qui est commandé par le signal de sortie (MCLK).

5. Circuit selon la revendication 4, **caractérisé en ce que** le signal de sortie (MCLK) d'un circuit diviseur (3) est envoyé à un circuit diviseur (30), dont le signal de sortie commande l'accumulateur de différence de phase (22) et le modulateur sigma-delta (26).

6. Circuit selon la revendication 5, **caractérisé en ce que** le rapport de division du circuit diviseur (30) correspond au rapport du signal de sortie (MCLK) au signal (SYNC), éventuellement après la conversion du rythme de cadence par l'autre modulateur sigma-delta (20).

7. Circuit selon l'une des revendications précédentes, **caractérisé en ce que** le modulateur sigma-delta (26) est agencé sous la forme d'un additionneur binaire, qui additionne les valeurs provenant du comparateur de phase (18) et que les sorties de dépassement de capacité positif et négatif de l'additionneur sont utilisées pour produire les instructions de correction (commande, direction).

8. Circuit selon l'une des revendications 2 à 7, **caractérisé en ce que** l'accumulateur de différence de phase (22) comporte un circuit (200) pour identifier un dépassement de capacité positif ou négatif du détecteur de phase (18), dont la sortie est reliée à un compteur (206), qui lors de chaque dépassement de capacité positif exécute un comptage progressif et lors de chaque dépassement de capacité négatif exécute un comptage régressif.

9. Circuit selon l'une des revendications 1 à 8, **caractérisé en ce qu'**on choisit respectivement 4 en tant que valeur pour m et n.

FIG 1

FIG 1A

## FIG 2

Grund-
Phasendiff.
max. 4*pi → 5 → BUF (202) → Komparator (200)

OV → INC → Counter 11 Bit (206)
UR → DEC

11

5 → BUF (204)

16

Akkkumulierte
Phasendiff.

22

## FIG 3

p/p₀ → 6 → + ⊕ → 11 → Register 10 Bits (302) → DEC → command
direction

10

26

# FIG 4

# FIG 5